# EUROPEAN PATENT APPLICATION

(11) **EP 2 348 805 A2**
(43) Date of publication of application: **27.07.2011**
(21) Application number: 11152261.1
(22) Date of filing: 26.01.2011
(51) Int. Cl.: H05K 13/08

(54) **A method of indicating component pickup position and an electronic component mounting apparatus**

(30) Priority: 26.01.2010 JP 2010014250
(71) Applicant: Hitachi High-Tech Instruments Company, Ltd., Saitama 360-0238 (JP)
(72) Inventor: Ono, Tetsuji, Saitama (JP); Kumagai, Daisuke, Saitama (JP); Yoshii, Takashi, Gunma (JP)
(74) Representative: Glawe, Delfs, Moll

(57) **Abstract**

The invention enables indicating a component pickup position for a pickup member even when an electronic component is too large to capture within a field of view of a camera. By specifying a disposition number of a component feeding unit (5) on a screen for indicating a component suction position, a CPU (50) reads out the size data of the corresponding electronic component from corresponding component library data based on the disposition number data of the component feeding unit (5), and calculates a dividing number and dividing center positions. Then a board recognition camera (4) is moved to positions (A) to (D) and takes images there respectively, thereby obtaining the images of the whole electronic component (D). The CPU (50) then displays a composed image and a nozzle graphic (NG) of a suction nozzle in a reference position, shifts the nozzle graphic (NG) to a desired suction position by operating a direction switch (56A), and determines this. The CPU (50) then reads the coordinates of the determined position of the nozzle graphic (NG), calculates the difference from the reference position, and stores it in a RAM (51).

## Description

### BACKGROUND OF THE INVENTION

### Field of the Invention

The invention relates to a method of indicating a component pickup position and an electronic component mounting apparatus, in which a pickup member picks up an electronic component in a component pickup position from a component feeding device.

### Description of the Related Art

This type of method of indicating a component pickup position is disclosed in the Japanese Patent Application Publication No. 2004-146661 and so on, for example. In the Japanese Patent Application Publication No. 2004-146661, an image taken in a component feeding position of a component feeding unit by a board recognition camera and a graphic of a suction nozzle are displayed on a screen of a display device so as to overlap, the graphically displayed suction nozzle as a pickup member and the component feeding position are aligned by alignment means to recognize the shifting amount for the alignment, and the component pickup position is corrected by this shifting amount.

However, in a case of taking an image of a component pickup position of a component feeding device by a camera at one time, it is difficult to indicate a component pickup position of an electronic component that is too large to capture within the field of view of the camera.

### SUMMARY OF THE INVENTION

Therefore, it is an object of the invention is to enable indicating a component pickup position for a pickup member picking up an electronic component from a component feeding device even when the electronic component is too large to capture within a field of view of a camera.

The solution according to the invention resides in the features of the independent claims and preferably in those of the dependent claims.

The invention provides a method of indicating a component pickup position in which a pickup member picks up an electronic component from a component feeding device that feeds electronic components, the method including: calculating a dividing number for dividedly taking a plurality of images of a desired electronic component based on a size of the electronic component; taking images of the whole electronic component by repeating dividedly taking an image of the electronic component located in a component pickup position of the component feeding device the calculated dividing number of times; composing an image of the electronic component using the plurality of images that are dividedly taken; displaying the composed image of the electronic component and a graphic of the pickup member for alignment on a monitor; shifting the composed image of the electronic component and the graphic relatively that are displayed on the monitor so as to align the component pickup position in the composed image of the electronic component and the graphic; and storing an amount of the shifting in a memory means.

The invention also provides an electronic component mounting apparatus in which a pickup member picks up an electronic component in a component pickup position from a component feeding device that feeds electronic components and mounts the electronic component on a board, the apparatus including: a calculation means calculating a dividing number for dividedly taking a plurality of images of a desired electronic component based on a size of the electronic component; a camera taking images of the whole electronic component by dividedly taking an image of the electronic component located in a component pickup position of the component feeding device the dividing number of times calculated by the calculation means; a composing means composing an image of the electronic component using the plurality of images that are dividedly taken by the camera; a monitor displaying the image of the electronic component composed by the composing means and a graphic of a pickup member for alignment; an alignment means shifting the image of the electronic component and the graphic relatively that are displayed on the monitor so as to align the component pickup position in the composed image of the electronic component and the graphic; and a memory means storing an amount of the shifting by the alignment means.

In the invention, a plurality of images that are dividedly taken are used to compose an image, the composed image of an electronic component and a graphic of a pickup member for alignment are displayed on a monitor, and the graphic is shifted so as to align with the component suction position of the composed image of the electronic component. Alternatively, the image may be shifted so as to align with the graphic. This image and the graphic are shifted relatively and the shifting amount is stored in memory means, thereby obtaining the effect as described above.

### BRIEF DESCRIPTION OF THE DRAWINGS

Fig. 1 is a plan view of an electronic component mounting apparatus.
Fig. 2 is a front view of a second component feeding device.
Fig. 3 is a front view of the second component feeding device of which the cover body is removed.
Fig. 4 is a cross-sectional plan view of the second component feeding device of which the cover body is removed.
Fig. 5 is a longitudinal sectional view of the second component feeding device of which the cover body is removed.
Fig. 6 is a right side view of a part of the electronic component mounting apparatus.
Fig. 7 is a front view of the second component feeding device of which the cover body is removed.
Fig. 8 is a partial plan view of a component feeding unit.
Fig. 9 is a partial longitudinal sectional view of the component feeding unit.
Fig. 10 is a control block diagram.
Fig. 11 is a flow chart of indicating a component suction position.
Fig. 12 shows four photo areas divided for taking images in the component pickup position of the component feeding unit.
Fig. 13 is a view displaying a composed image and a nozzle graphic of a suction nozzle.
Fig. 14 is a view displaying a composed image, a nozzle graphic of a suction nozzle and a component graphic.
Fig. 15 shows a tray and photo areas.
Fig. 16 is a view displaying a composed image and a nozzle graphic of a suction nozzle.
Fig. 17 is a view displaying a composed image, a nozzle graphic of a suction nozzle and a component graphic.

### DETAILED DESCRIPTION OF THE INVENTION

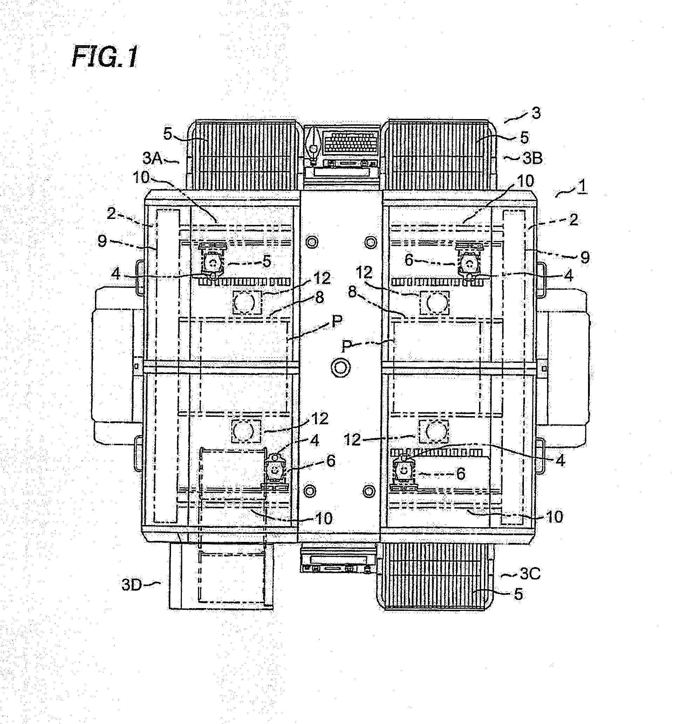

An embodiment of the invention will be described referring to figures. Fig. 1 is a plan view of an electronic component mounting apparatus 1, and a plurality of component feeding devices 3 are provided in four blocks on the front and rear portions of an apparatus body 2 of the electronic component mounting apparatus 1.

The component feeding devices 3 includes first component feeding devices 3A, 3B, 3C and a second component feeding device 3D. The first component feeding devices 3A, 3B, 3C are detachably mounted on the apparatus body 2 through connectors (not shown) so that the end portions on the component feeding sides face on a lane for carrying a printed board P, and by releasing the connectors and pulling the handles (not shown) the carts are movable with the casters provided on the lower sides.

Between the first component feeding devices 3A, 3B and the first component feeding device 3C and the second component feeding device 3D, that are opposite to each other, a supply conveyer, positioning portions 8 (having conveyors) and a discharging conveyer that form a board carrying mechanism is provided. The supply conveyer carries a plurality of printed boards P received from an upstream device to the positioning portions 8, and electronic components are mounted on the boards P that are positioned on the positioning portions 8 by a positioning mechanism (not shown), and then the boards P are carried to the discharging conveyer and carried to a downstream device.

Beams 10 move along guide rails 9 in the Y direction driven by Y direction linear motors 61, and mounting heads 6 that move in the X direction driven by X direction linear motors 62 are provided on the beams 10, respectively. The mounting head 6 has suction nozzles 7 as electronic component pickup members that pick up electronic components by suction. The suction nozzle 7 is vertically movable and rotatable around the vertical axis by a vertical axis motor 63 and a θ axis motor 64. Instead of the suction nozzle 7, a grasp member having a mechanism that picks up an electronic component by grasping it may be used as a pickup member, for example.

4 indicates a board recognition camera that takes an image of a recognition mark on a printed board P for checking the position and is mounted on each of the mounting heads 6. 12 indicates a component recognition camera provided on the apparatus body 2 for each of the mounting heads 6, that takes an image of an electronic component picked up from the component feeding device 3 and held by the suction nozzle 7, and the position of the electronic component relative to the suction nozzle 7 is recognized by a recognition processing device 53.

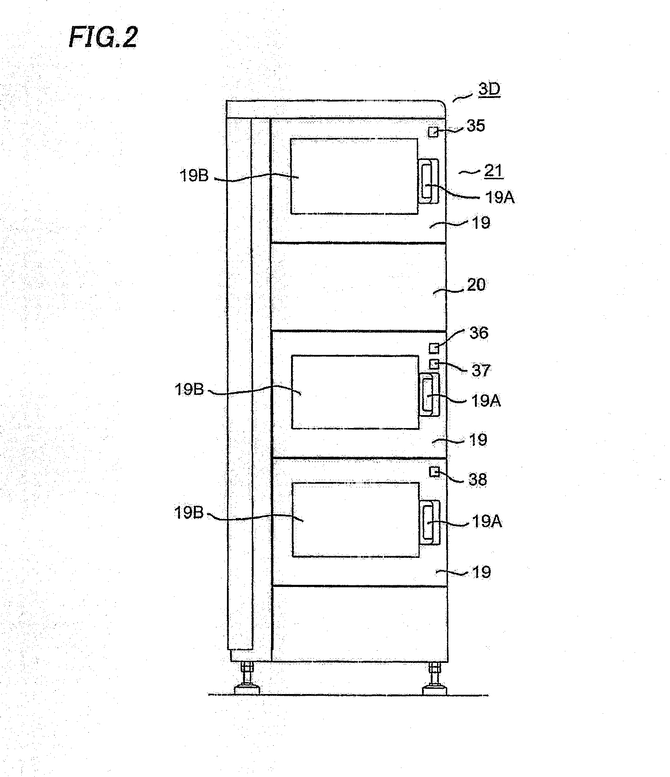

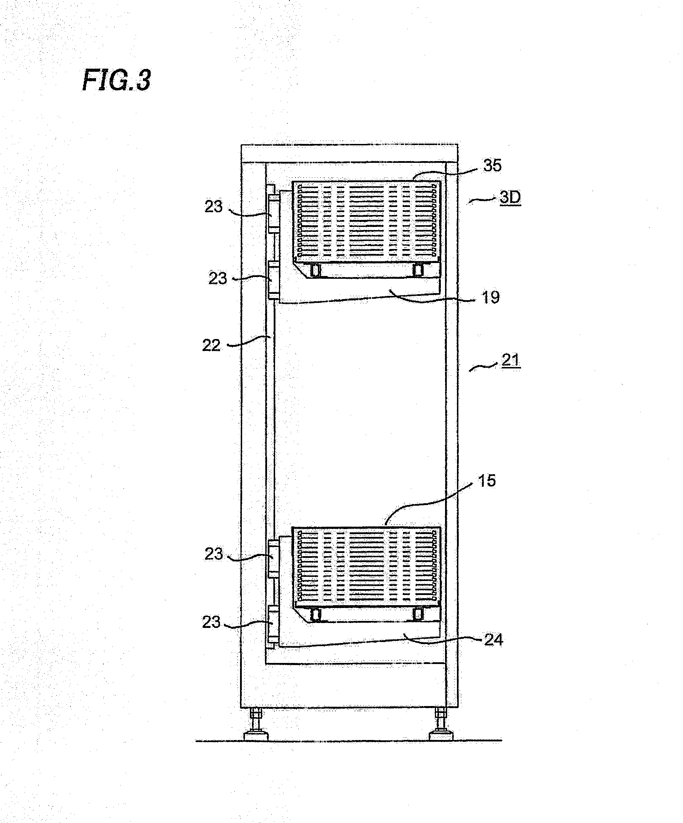

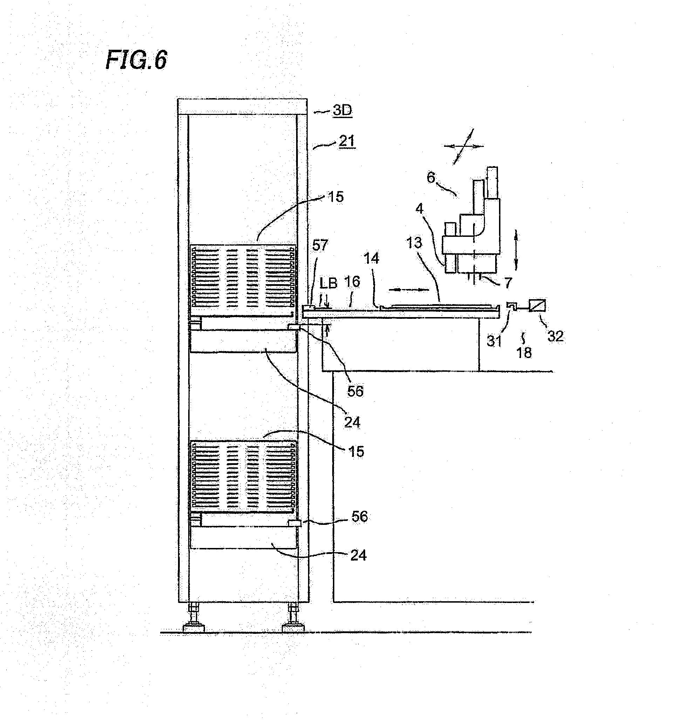

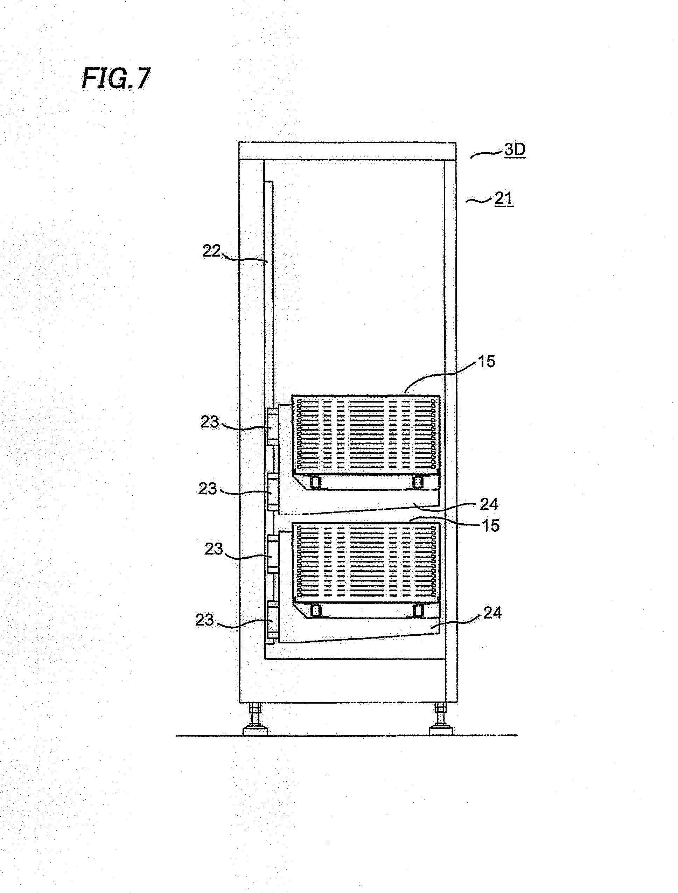

Next, the second component feeding device 3D that is detachably mounted on the electronic component mounting apparatus 1 will be described in detail hereafter referring to Figs. 2 to 7. The second component feeding device 3D has a feeding device body 21 having a cover body 20 that covers an opening portion provided on one side and has door bodies 19 opening or closing openings for taking out a magazine 15 for replacement in the upper, middle and lower positions. This feeding device body 21 has two magazines 15 in which pallets 14 are stored on a plurality of levels, the pallets 14 each having a tray 13 on which electronic components are arrayed in a plurality of storage concave portions 13A that are tetragonal in a plan view and formed in a grid at constant intervals, an elevator mechanism 17 that vertically carries a predetermined pallet 14 of either one of the magazines 15 to a drawing level position that is a predetermined transferring level position (the position of a chute 16 provided on the electronic component mounting apparatus 1) or to a position for replacing the magazine 15, and a pallet transfer mechanism 18 that carries the pallet 14 from the elevator mechanism 17 to the pickup area of the apparatus body 2 in the horizontal direction.

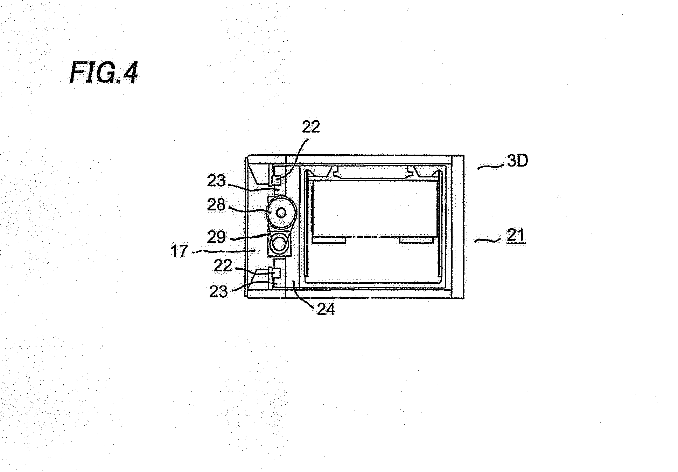

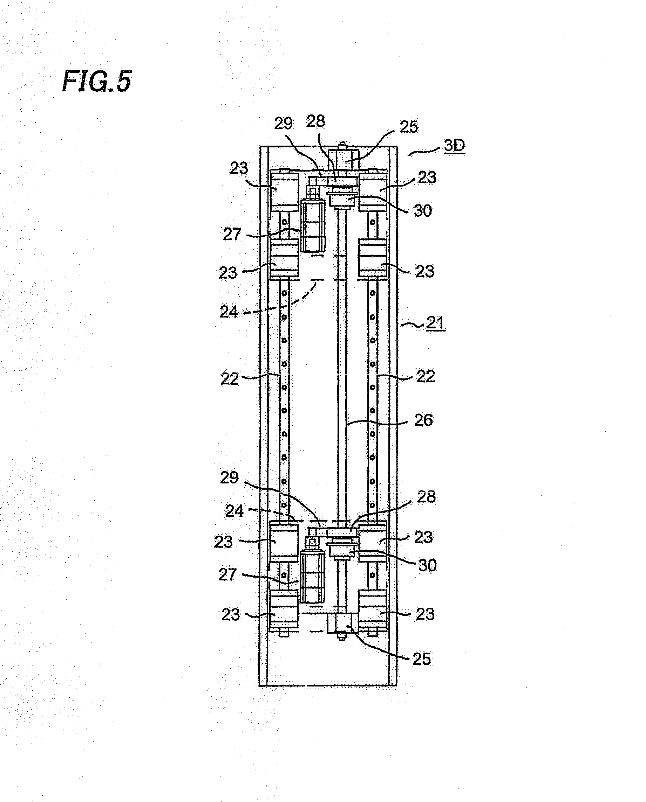

As shown in Figs. 4 and 5, the elevator mechanism 17 has two guide rails 22, magazine bases 24 each having sliders 23 vertically movable along these guide rails 22 on the side portion and each forming an L shape in a sectional view on which the magazine 15 is mounted, a ball screw 26 fixed to upper and lower fixing blocks 25 between the two guide rails 22, two forward/reverse rotatable vertical movement drive motors 27 having an encoder function, belts 29 each stretched between the output shaft of each of the vertical movement drive motors 27 and a pulley 28 rotatable around the ball screw 26, and nuts 30 each moving along the ball screw 26 by rotating together with the belt 29. The vertical movement drive motor 27 as well as the sliders 23 are fixed to the magazine base 24, and a bearing body (not shown) is provided between this magazine base 24 and the nut 30.

Therefore, when the vertical movement drive motor 27 is driven forwardly or reversely, the pulley 28 and the nut 30 rotate around the ball screw 26 through the belt 29, and the magazine base 24 is vertically movable along the guide rails 22 through the sliders 23 without rotating by the bearing body (not shown).

The vertical movement of the elevator mechanism 17 thus structured enables aligning the level position of a desired one of the pallets 14 in the upper and lower magazines 15 and the level position of the chute 16, transferring the tray 13 of the pallet 14 to the pickup area by the pallet transfer mechanism 18, and thus picking up an electronic component by suction by the suction nozzle 7.

The pallet transfer mechanism 18 includes the chute 16 mounted on the apparatus body 2, a hook arm 31 moving forward and backward along this chute 16, and a drive mechanism 32 moving this hook arm 31 forward and backward. The end of the hook arm 31 has a hook that is hooked on or released from the pallet 14. The hook arm 31 is moved forward by the drive mechanism 32, this hook is then hooked on the end of the pallet 14 stored in the magazine 15, and the hook arm 31 is then moved backward to transfer the pallet 14 to the pickup area along the chute 16.

An operation switch 35 for moving the upper magazine 15 upward is provided on the upper door body 19, operation switches 36, 37 for moving the upper or lower magazine 15 upward and downward are provided on the middle door body 19, and an operation switch 38 for moving the lower magazine 15 downward is provided on the lower door body 19. Furthermore, a handle 19A and a transparent or semitransparent window 19B are provided on each of the door bodies 19 in the same manner.

When the magazine 15 need be replaced for a setup change of printed boards P or when the multiple pallets 14 on which the trays 13 storing predetermined components are mounted need be replaced, by operating any one of the operation switches 35, 36, 37, 38 in the state where the electronic component mounting apparatus is stopped, a CPU 50 as a control device controlling the electronic component mounting apparatus drives the vertical movement drive motor 27 so as to move the corresponding magazine 15 upward or downward to the position of the door body 19. When this movement is stopped, the CPU 50 drives the drive source of a lock mechanism (not shown) of the door body 19 to release the lock.

In detail, by operating the operation switch 35, the CPU 50 drives the upper vertical movement drive motor 27 to move the upper magazine 15 to the position of the upper door body 19. By operating the operation switch 36, the CPU 50 drives the upper vertical movement drive motor 27 to move the upper magazine 15 to the position of the middle door body 19. By operating the operation switch 37, the CPU 50 drives the lower vertical movement drive motor 27 to move the lower magazine 15 to the position of the middle door body 19. By operating the operation switch 38, the CPU 50 drives the lower vertical movement drive motor 27 to move the lower magazine 15 to the position of the lower door body 19.

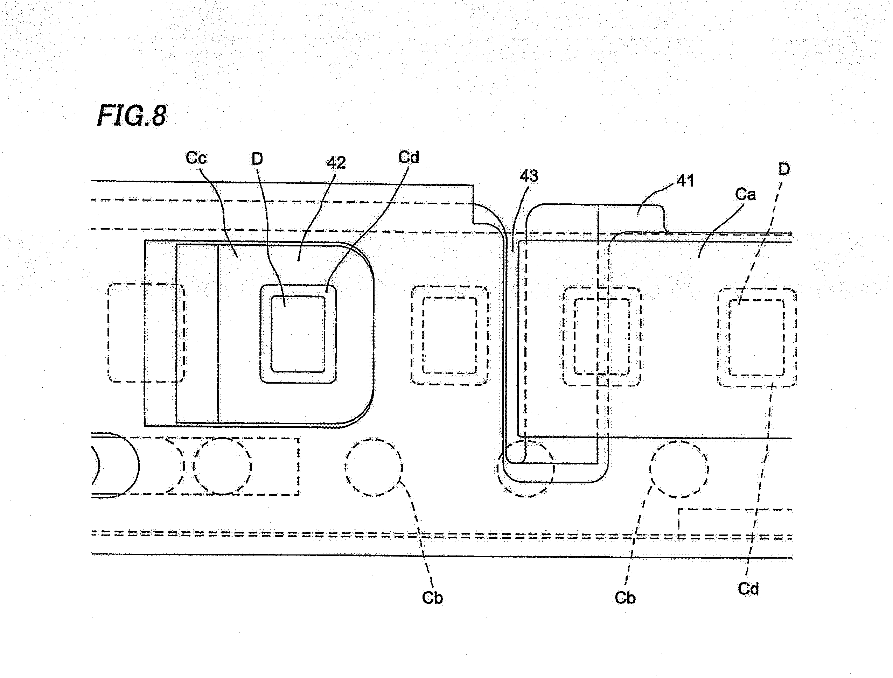

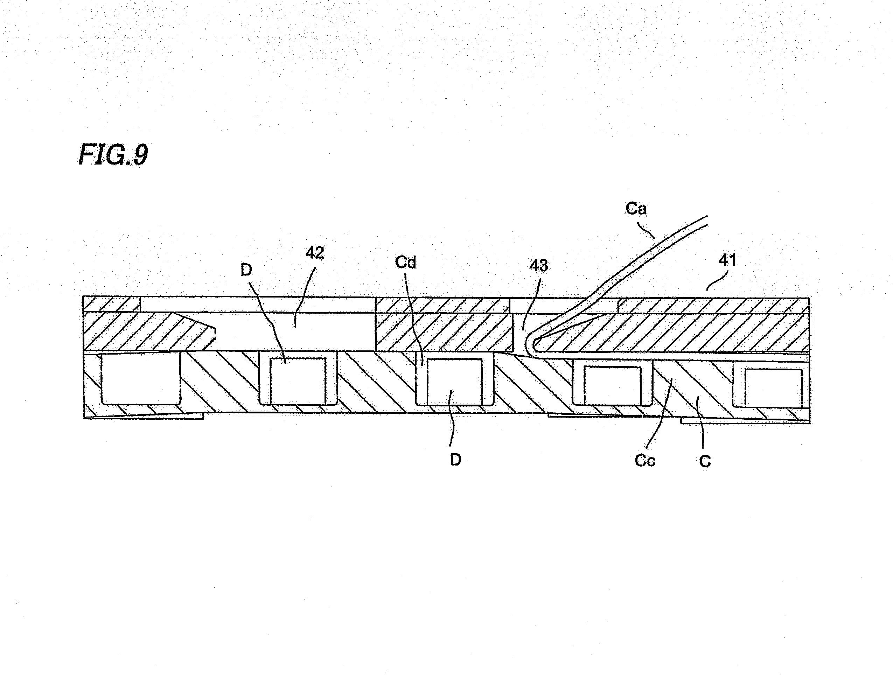

Next, a component feeding unit 5 that corresponds to the first component feeding devices 3A, 3B, 3C will be described referring to Figs. 8 and 9. First, the component feeding unit 5 has a tape forwarding mechanism that intermittently forwards a storage tape C to an electronic component pickup position by a forwarding motor 44 by turning a forwarding sprocket by a given angle, the teeth of the forwarding sprocket being engaged with forwarding holes Cb formed at given intervals in the storage tape C sequentially forwarded from a feed reel on which the storage tape C is wound, the feed reel being rotatably set on the cart. The component feeding unit 5 also has a cover tape peeling mechanism that peels a cover tape Ca from a carrier tape Cc in a position before the component pickup position by a peeling motor 45. The cover tape Ca is peeled by the cover tape peeling mechanism, and electronic components stored in the storage concave portions Cd formed in the carrier tape Cc at given intervals are sequentially fed to the component pickup position and picked up at the end portion by the suction nozzles 7.

The storage tape C in which multiple electronic components D are respectively stored in the storage concave portions Cd of the carrier tape Cc at constant intervals is let out from the storage tape reel and forwarded to the component pickup position under a suppressor 41. An opening 42 for picking up a component by the suction nozzle 7 is provided in this suppressor 41. A slit 43 is formed in the suppressor 41. The cover tape Ca of the storage tape C is peeled off at this slit 43, and stored in a storage portion formed in the component feeding unit 5. In detail, an electronic component stored in the storage tape C is fed to the component pickup position, with the cover tape Ca being peeled off, and picked up by the suction nozzle 7 through the opening 42.

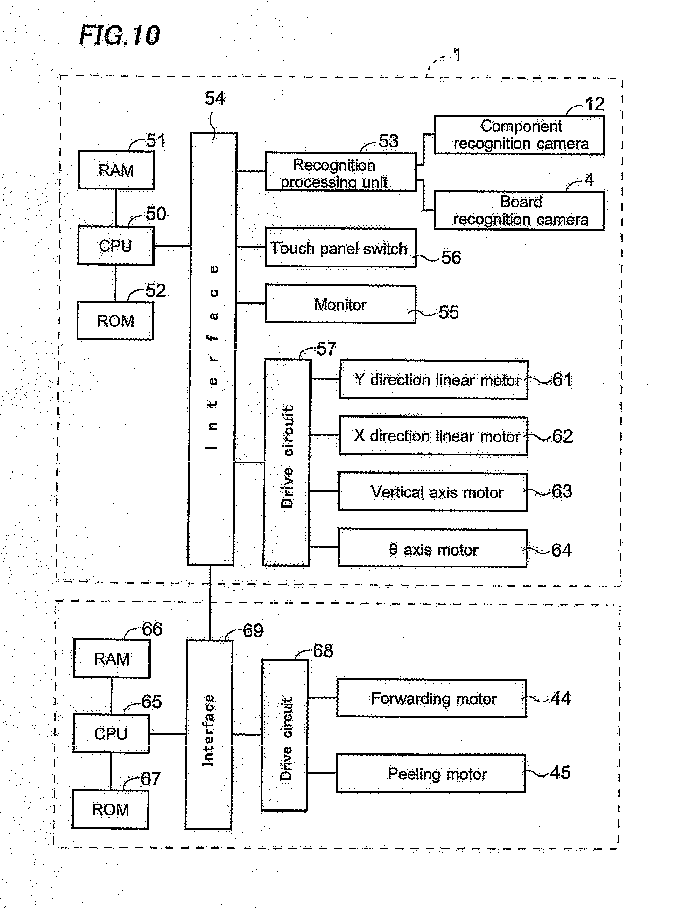

Next, a control block diagram in Fig. 10 will be described. The electronic component mounting apparatus 1 includes the CPU (central processing unit) 50 as a control device controlling the mounting apparatus 1, and a RAM (random access memory) 51 and a ROM (read only memory) 52 connected to the CPU 50 through buses. The CPU 50 controls operations relating to the component mounting operation of the electronic component mounting apparatus 1 based on data stored in the RAM 51 and according to programs stored in the ROM 52. In detail, the CPU 50 controls the driving of the Y direction linear motor 61, the X direction linear motor 62, the vertical axis motor 63, the θ axis motor 64 and so on through an interface 54 and a drive circuit 57 and also controls each of the component feeding units 5. In Fig. 10, for simplifying the description, even though there are a plurality of devices, for example, the mounting heads 6, the component feeding units 5 and so on, one of these is shown for the description and the other is omitted.

The RAM 51 stores mounting data for each of the types of printed boards P for component mounting, in which data about the X direction (indicated by X), the Y direction (indicated by Y) and an angle (indicated by Z) on each of the printed boards P, data about the disposition numbers of the component feeding units 5, and so on are stored in mounting order (in order of step number).

Furthermore, the RAM 51 stores data about the type (component ID) of each of electronic components corresponding to the component feeding unit disposition numbers (lane numbers) of the component feeding units 5 and the disposition numbers of the trays 13 of the upper and lower magazines 15 for each of the types of printed boards P, i.e., component disposition data. These component disposition data are data about positions on the cart where the component feeding units 5 are to be mounted respectively and data about positions in the magazine 15 where the trays 13 are to be mounted respectively. Furthermore, the RAM 51 stores component library data about the features of electronic components and so on for the component IDs respectively.

53 indicates a recognition processing device connected to the CPU 50 through the interface 54. The recognition processing device 53 performs recognition processing to images taken and stored by the component recognition camera 12, and sends the recognition result to the CPU 50. In detail, the CPU 50 outputs a command to perform recognition processing (e.g. the calculation of a shifting amount of an electronic component from a proper position) to images taken and stored by the component recognition camera 12 to the recognition processing device 53, and receives the recognition process result from the recognition processing device 53.

55 indicates a monitor displaying a component image and a screen for setting various data. Various touch panel switches 56 are provided on this monitor 55 as input means, and an operator performs various settings by operating the touch panel switches 56.

The component feeding unit 5 that intermittently forwards the storage tape C by the forwarding motor 44 includes a CPU 65, a RAM 66 and a ROM 67. 68 indicates a drive circuit connected to the CPU 65 through an interface 69, and the CPU 65 controls the forwarding motor 44 and the peeling motor 45 through the drive circuit 68. The CPU 65 provided on this component feeding unit 5 is connected to the CPU 50 provided on the electronic component mounting apparatus 1 through the interfaces 69, 54.

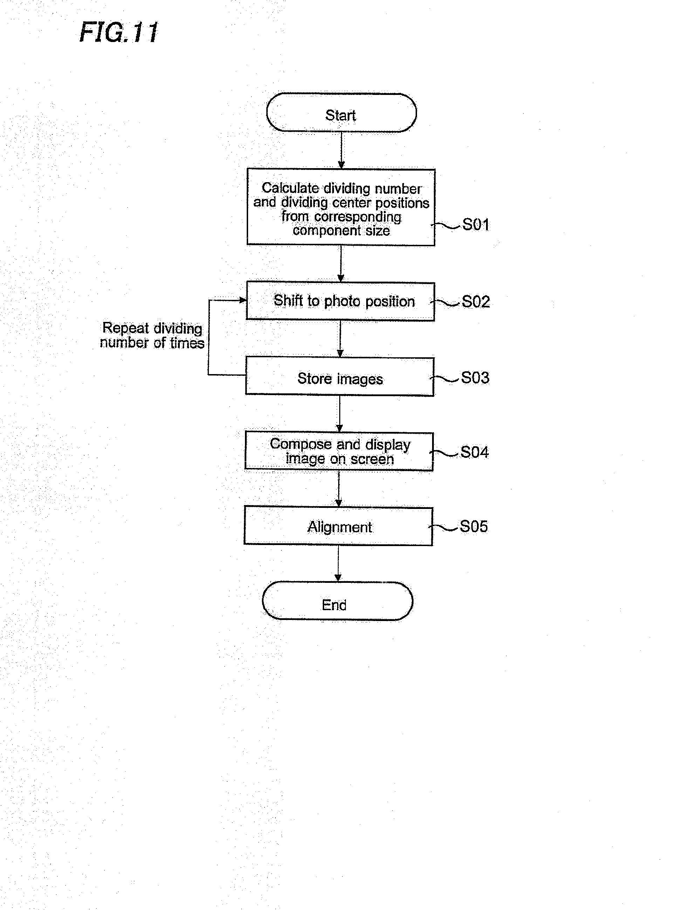

Next, referring to Fig. 11 showing a flow chart of a method of indicating an electronic component pickup position, that enables indicating an electronic component pickup position, a description will be given about a case where an electronic component D in the storage concave portion Cd at the opening 42 of the component feeding unit 5 is too large to capture within the field of view of the board recognition camera 4, for example. First, by operating the touch panel switches 56 formed on the display screen of the monitor 55, an operation manager selects a screen for indicating an electronic component pickup position from a displayed menu screen to display this screen and starts indication.

First, the indication of a position to pick up an electronic component by suction from the component feeding unit 5 corresponding to the first component feeding devices 3A, 3B, 3C will be described. When the disposition number of the component feeding unit 5 is specified on the screen for indicating a suction position, the CPU 50 reads the size data of the electronic component for indication from the corresponding component library data based on the data about the disposition number of the component feeding unit 5 stored in the RAM 51, and calculates a dividing number and dividing center positions (step S01).

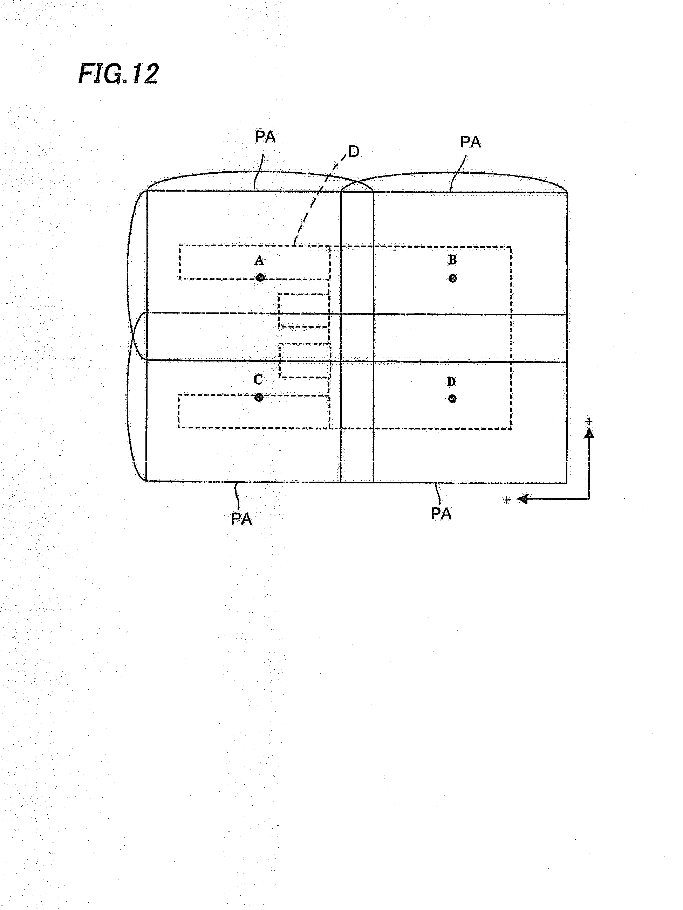

In this case, for example, as shown in Fig. 12 showing photo areas PA, the calculated dividing number is four, and the coordinates of the dividing center positions (the photo center position of the board recognition camera 4) are a point A (+11, +5), a point B (-11, +5), a point C (+11, -5) and a point D (-11, -5). These four photo areas PA including the two upper photo areas and the two lower photo areas are partially overlapped so that there is no missing area.

It is noted that this dividing number may be calculated and stored in the RAM 51 in advance as a part of the component library data for each of the component IDs, and the CPU 50 may read out the dividing number data from the RAM 51.

Then the CPU 50 performs component feeding in the component feeding unit 5 having the specified disposition number so as to feed an electronic component D for indication to the component pickup position. However, the indicating work relating to the flow chart in Fig. 11 may be performed after the electronic component is fed to the component pickup position. Furthermore, the CPU 50 moves the board recognition camera 4 corresponding to the component feeding unit 5 for indication to the position of the point A first by controlling the Y direction linear motor 61 and the X direction linear motor 62 (step S02), and takes an image of the electronic component D in the storage concave portion Cd of the carrier tape Cc through the opening 42 in the component pickup position and stores this (step S03). Then the CPU 50 moves the camera 4 to the point B that is the next photo position and takes an image there. The moving and image-taking are thus repeated from the point A to the point D that are the photo positions sequentially, completing taking images of the whole electronic component D.

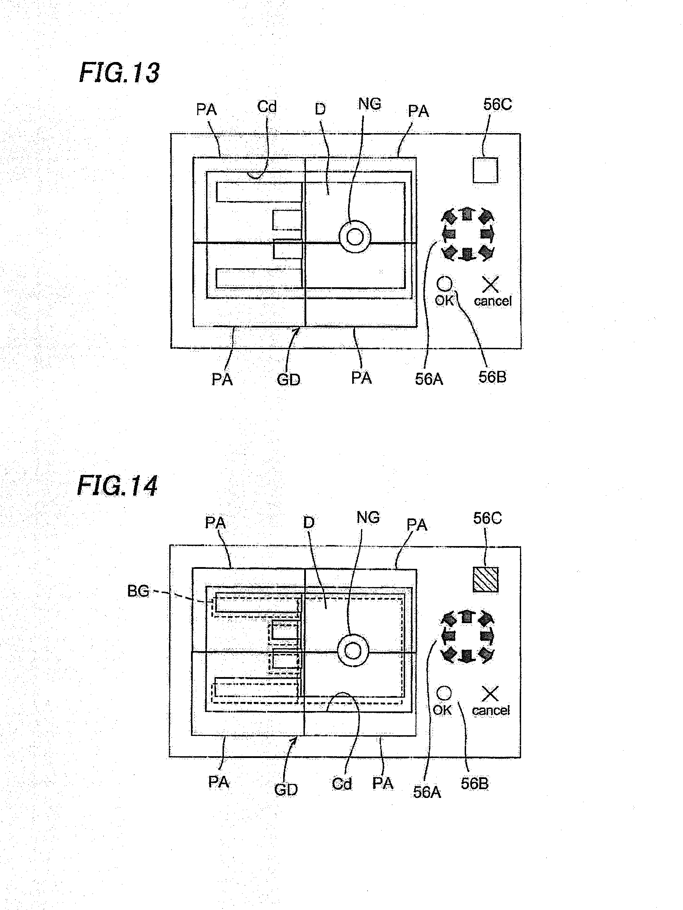

Then the CPU 50 composes an image using the dividedly obtained four images of the electronic component D having two long leads and two short leads on one side of the mold, and displays it on the monitor 55 as shown in Fig. 13 (step S04). In this case, on the monitor 55, the CPU 50 displays the composed image GD of the whole electronic component D and the nozzle graphic NG of the suction nozzle 7 in the reference position of the suction nozzle 7 for picking components that is stored in the RAM 51. Although it is preferable that the reference position is at the center of the outer shape of the electronic component or the center of the storage concave portion Cd, it is ideal that the reference position is at the center of the screen of the monitor 55 since the position of the electronic component or storage concave portion varies.

Then, by an operation manager operating a "direction" switch 56A indicating eight directions as the touch panel switch 56 displayed on the display screen of the monitor 55, the CPU 50 shifts the nozzle graphic NG of the suction nozzle 7 to a desired pickup position. In detail, the suction position of the electronic component D for the suction nozzle 7 is indicated in order to pick up the connector component as the electronic component D in the storage concave portion Cd of the carrier tape Cc in the component pickup position. It is noted that the composed image GD may be shifted instead of the nozzle graphic NG.

Then when the suction position of the electronic component D is determined, the operation manager operates an "OK" switch 56B that is the touch panel switch 56, thereby completing alignment (step S05). By the operation of this "OK" switch 56B, the CPU 50 reads the coordinates of the determined position (the center position) of the nozzle graphic NG, calculates the difference between the reference position of the suction nozzle 7 for picking components and the determined position of the nozzle graphic NG. (the shifting amount of the nozzle graphic NG from the reference position), and stored it in the RAM 51. The difference may be stored in the RAM 51 as the coordinates relative to the reference position as an origin. Alternatively, other origin may be used for the coordinates, instead of the reference position.

By this, when a printed board P is manufactured in actual, the CPU 50 controls the Y direction linear motor 61 and the X direction linear motor 62 so as to move the suction nozzle 7 and adjust the suction position for the suction nozzle 7 based on the difference between the reference position and the determined position of the nozzle graphic NG. Therefore, the suction position becomes proper, and the electronic component D is picked up from the component feeding unit 5 without fail.

It is noted that the grasp member mentioned above may be used as a pickup member instead of the suction nozzle 7.
In the case of the grasp member, too, in the same manner to the case of the suction nozzle 7, the graphic of the grasp member is displayed on the monitor 55 together with an image of an electronic component, and the composed image of the electronic component and the graphic of the grasp member are shifted relatively, thereby enabling indicating the grasp position as the pickup position of the electronic component.

Furthermore, as described above, when an image of an electronic component that is composed using four divided images is displayed on the monitor 55 together with the nozzle graphic NG of the suction nozzle 7 (Fig. 13), if the composed image is not clear, the operation manager operates a "component graphic display" switch 56C that is the touch panel switch 56. Then the CPU 50 makes a control to display a component graphic BG corresponding to this electronic component on the monitor 55 (Fig. 14). This component graphic BG is displayed in a position where the electronic component is supposed to be stored without leaning to one side. For example, the center of the outer shape of the component graphic BG is displayed at the center of the screen of the monitor 55.

The operation manager then operates the "direction" switch 56A to command shifting the component graphic BG so that the component graphic BG aligns with the unclear composed image of the electronic component D, and CPU 50 shifts the component graphic BG accordingly. By this, when a lead portion is not clearly displayed in the dark, and so on, for example, the position of the lead portion is observable. Then, the operation manager operates the "OK" switch 56B to determine the position of the component graphic BG, and shifts the nozzle graphic NG of the suction nozzle 7 to a desired suction position by operating the "direction" switch 56A again, thereby indicating the suction position of the electronic component D for the suction nozzle 7 for picking up the electronic component D.

Then, when the operation manager operates the "OK" switch 56B, the CPU 50 reads the coordinates of the determined position (the center position) of the nozzle graphic NG, calculates the difference from the reference position of the suction nozzle 7 for pickup suction (the shifting amount of the nozzle graphic NG from the reference position), and stores it in the RAM 51.

It is noted that the difference from the reference position (the shifting amount of the nozzle graphic NG from the reference position) may be stored in the component library data of the corresponding component ID in the RAM 51 mentioned above. By transferring this component library data to a management computer or other electronic component mounting apparatus, the indication result is reusable.

As described above, since the suction position is determined by displaying the component graphic BG on the monitor 55 and shifting the component graphic BG so as to align this with the image, the suction position of the electronic component D is determined even when the composed image is not clear.

Next, a description will be given about indicating a suction position of an electronic component in the second component feeding device 3D in a case where an electronic component D in the tray 13 is too large to capture within the field of view of the board recognition camera 4, for example. The flow relating to the basic operation is the same as in the case of the component feeding unit 5, and the description will be given referring to the flow chart in Fig. 11 hereafter.

First, by operating the touch panel switches 56 formed on the display screen of the monitor 55, an operation manager selects a screen for indicating a suction position from a displayed menu screen to display this screen and starts indication.

First, the indication of a position to pick up an electronic component by suction from the tray 13 in the second component feeding device 3D will be described. When the disposition number of the tray 13 in the upper or lower magazine 15 is specified on the screen for indicating a suction position, the CPU 50 reads the size data of the electronic component for indication from the corresponding component library data based on the data about the disposition number of the tray 13 stored in the RAM 51, and calculates a dividing number and dividing center positions (step S01).

In this case, for example, the calculated dividing number is four, and four photo areas are partially overlapped so that there is no missing area.

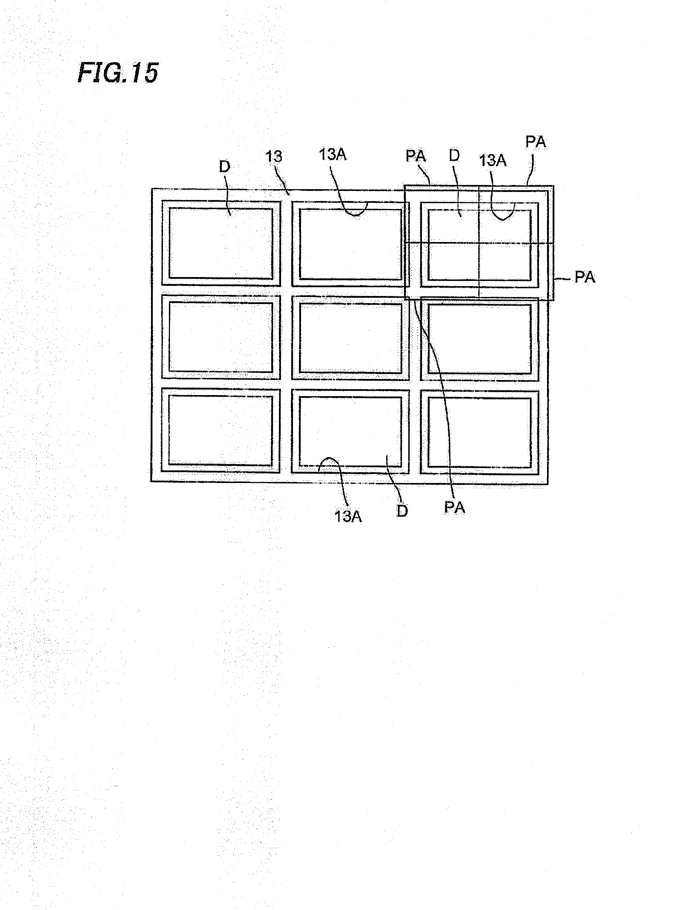

Then the CPU 50 drives the vertical movement drive motor 27 to drive the elevator mechanism 17 and move the magazine 15 so as to align the level position of the pallet 14 of the magazine 15 storing the electronic component for indication and the level position of the chute 16 of the pallet transfer mechanism 18. The CPU 50 then moves the hook arm 31 forward by the drive mechanism 32, hooks the hook on the end of the pallet 14 stored in the magazine 15, moves the arm 31 backward, and transfers the pallet 14 to the pickup area along the chute 16. However, the indicating work relating to the flow chart in Fig. 11 may be performed after the pallet 14 is transferred to the pickup area. By controlling the Y direction linear motor 61 and the X direction linear motor 62, the board recognition camera 4 corresponding to this component feeding device 3D is moved to the photo position of the storage concave portion 13A, that is shown in the right rear portion of Fig. 15, in the tray 13 mounted and positioned on the pallet 14 (step S02), takes an image of the component storage concave portion 13A of the tray 13 in the component pickup position and stores the image (step S03). Then the moving and image-taking are performed in the next photo position, and these are repeated in the four photo positions sequentially, thereby completing taking images of the whole electronic component D (see Fig. 15 showing the tray 13 and the photo areas PA). The calculation of the image dividing number in this case is also performed based on the component size data in the same manner as described above.

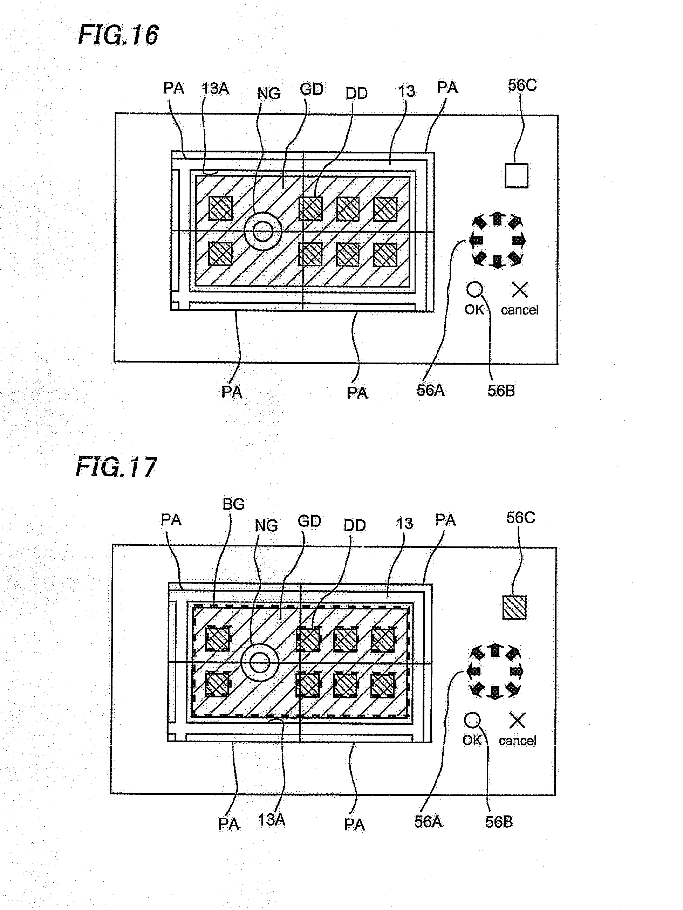

Then the CPU 50 composes an image using the four images dividedly taken as above, and displays it on the monitor 55 as shown in Fig. 16 (step S04). In this case, on the monitor 55, the CPU 50 displays the composed image GD of the electronic component D and the nozzle graphic NG of the suction nozzle 7 in the reference position of the suction nozzle 7 for picking components that is stored in the RAM 51.

However, when this displayed nozzle graphic NG is displayed at the center position of the electronic component D as the reference position (the center position of the electronic component that is supposed to be ideally positioned) and on the lead DD, it is not preferable to indicate this position as the suction position. Therefore, the operation manager operates the "direction" switch 56A indicating eight directions as the touch panel switch 56 displayed on the display screen of the monitor 55 to move the nozzle graphic NG to a desired suction position (the position of the nozzle graphic NG shown in Fig. 16) avoiding on the lead DD.

Then when the suction position of the electronic component D is determined, the operation manager operates the "OK" switch 56B that is the touch panel switch 56, thereby completing alignment (step S05). By the operation of this "OK" switch 56B, the CPU 50 reads the coordinates of the determined position (the center position) of the nozzle graphic NG, calculates the difference between the reference position of the suction nozzle 7 for picking components and the determined position of the nozzle graphic NG. (the shifting amount of the nozzle graphic NG from the reference position), and stored it in the RAM 51.

By this, when a printed board P is manufactured in actual, the CPU 50 controls the Y direction linear motor 61 and the X direction linear motor 62 so as to move the suction nozzle 7 and adjust the suction position for the suction nozzle 7 based on the difference between the reference position and the determined position of the nozzle graphic NG. Therefore, the suction position becomes proper, and the electronic component D is picked up from the tray 13 without fail.

In the tray 13, since the images are taken including the storage concave portion 13A in the right rear portion to determine the suction position of the electronic component in the storage concave portion 13A in the right rear portion, the intervals between the storage concave portions 13A in the X and Y directions are recognized. Therefore, by utilizing the intervals, the proper suction position is indicated for the electronic components in the other storage concave portions 13A as well as in the storage concave portion 13A in this right rear position, thereby enabling picking up electronic components D without fail.

When an image of an electronic component that is composed using four divided images is displayed on the monitor 55 together with the nozzle graphic NG of the suction nozzle 7 (Fig. 16), if the composed image is not clear, as described above, the operation manager operates the "component graphic display" switch 56C that is the touch panel switch 56. Then the CPU 50 makes a control to display a component graphic BG corresponding to this electronic component on the monitor 55 (Fig. 17).

The operation manager then operates the "direction" switch 56A to command shifting the component graphic BG so that the component graphic BG aligns with the unclear composed image of the electronic component D, and CPU 50 shifts the component graphic BG accordingly. By this, when a lead portion is not clearly displayed in the dark, and so on, for example, the position of the lead portion is observable. Then, the operation manager operates the "OK" switch 56B to determine the position of the component graphic BG, and shifts the nozzle graphic NG of the suction nozzle 7 to a desired suction position by operating the "direction" switch 56A again, thereby indicating the suction position of the electronic component D for the suction nozzle 7 for picking up the electronic component D.

Then, when the operation manager operates the "OK" switch 56B, the CPU 50 reads the coordinates of the determined position (the center position) of the nozzle graphic NG, calculates the difference from the reference position of the suction nozzle 7 for pickup suction (the shifting amount of the nozzle graphic NG from the reference position), and stores it in the RAM 51.

As described in the above embodiment, the suction position is determined by displaying the component graphic BG on the monitor 55 and shifting the component graphic BG so as to align this with the obtained image, thereby enabling determining the suction position of an electronic component D even when the composed image is not clear.

Thereafter, in a case of other type electronic components in the various component feeding units 5 or trays 13, too, by indicating a suction position for the suction nozzle 7 picking up the electronic component, the suction position becomes proper and the electronic component D is picked up by the suction nozzle 7 from these component feeding units 5 or trays 13 without fail.

As described above, in the invention, a plurality of images that are dividedly taken are used to compose an image, the composed image of an electronic component and a graphic of a pickup member for alignment are displayed on a monitor, and the graphic is shifted so as to align with the component suction position of the composed image of the electronic component. Alternatively, the image may be shifted so as to align with the graphic. This image and the graphic are shifted relatively and the shifting amount is stored in memory means, thereby obtaining the effect as described above.

Furthermore, the invention is not limited to a tape feeder or a tray feeder as described in the above embodiment, and also applicable to component feeding devices having other electronic component feeding styles.

The embodiment of the invention is described above. It is recognized that variations or modifications of the disclosed method are possible based on the disclosure for those skilled in the art and lie within the scope of the invention.

The invention enables indicating a component pickup position for a pickup member picking up an electronic component from a component feeding device even when the electronic component is too large to capture within a field of view of a camera. This enables picking up an electronic component located in the component pickup position of a component feeding device by a pickup member without fail.

## Claims

1. A method of indicating a component pickup position in which a pickup member (7) picks up an electronic component (D) from a component feeding device (5) that feeds electronic components (D), the method comprising:
calculating a dividing number for dividedly taking a plurality of images (PA) of a desired electronic component (D) based on a size of the electronic component (D);
taking images of the whole electronic component (D) by repeating dividedly taking an image (PA)of the electronic component (D) located in a component pickup position of the component feeding device (5) the calculated dividing number of times;
composing an image (GD) of the electronic component (D) using the plurality of images (PA) that are dividedly taken;
displaying the composed image (GD) of the electronic component (D) and a graphic (NG) of the pickup member for alignment on a monitor (55);
shifting the composed image (GD) of the electronic component (D) and the graphic (NG) relatively that are displayed on the monitor (55) so as to align the component pickup position in the composed image (GD) of the electronic component (D) and the graphic (NG);
and
storing an amount of the shifting in a memory means (51).

2. The method of claim 1, wherein the calculated dividing number is stored in the memory means (51).

3. An electronic component mounting apparatus (1) in which a pickup member (7) picks up an electronic component (D) in a component pickup position from a component feeding device (5) feeding electronic components (D) and mounts the electronic component (D) on a board (P), the apparatus (1) comprising:
a calculation means (50) calculating a dividing number for dividedly taking a plurality of images (PA) of a desired electronic component (D) based on a size of the electronic component (D);
a camera (12) taking images of the whole electronic component (D) by dividedly taking an image (PA) of the electronic component (D) located in a component pickup position of the component feeding device (5) the dividing number of times calculated by the calculation means (50);
a composing means (50) composing an image (GD) of the electronic component (D) using the plurality of images (PA) that are dividedly taken by the camera (12);
a monitor (55) displaying the image (GD) of the electronic component (D) composed by the composing means (50) and the graphic (NG) of the pickup member (7) for alignment;
an alignment means (56) shifting the image (GD) of the electronic component (D) and the graphic (GD) relatively that are displayed on the monitor (55) so as to align the component pickup position in the composed image (GD) of the electronic component (D) and the graphic (NG); and
a memory means (51) storing an amount of the shifting by the alignment means (56).

4. The electronic component mounting apparatus of claim 3, wherein the dividing number calculated by the calculation means (50) is stored in the memory means (51).

5. The electronic component mounting apparatus of claim 3 or 4, further comprising a moving means (61,62) moving the pickup member (7) based on the amount of the shifting so as to adjust the component pickup position.
